# FASCICULE DE BREVET EUROPEEN

(11) **EP 3 925 014 B1**
(45) Date de publication et mention de la délivrance du brevet: **01.04.2026**
(21) Numéro de dépôt: 20713943.7
(22) Date de dépôt: 14.02.2020
(51) Int. Cl.: H10N 10/13, H10N 10/17, H01M 10/6572, B01J 13/00, H01M 10/42, H01M 10/659

(54) **DISPOSITIF THERMOELECTRIQUE A EFFET SEEBECK**
THERMOELEKTRISCHE VORRICHTUNG MIT SEEBECK-EFFEKT
THERMOELECTRIC DEVICE EMPLOYING THE SEEBECK EFFECT

(30) Priorité: 15.02.2019 FR 1901581
(43) Date de publication de la demande: 22.12.2021
(73) Titulaire: HUTCHINSON, 75008 Paris (FR)
(72) Inventeur: CHOPARD, Fabrice, 38400 SAINT MARTIN D'HERES (FR); GUAZZAGALOPPA, Jérémy, 34560 POUSSAN (FR); HUILLET, Cédric, 45200 MONTARGIS (FR)
(74) Mandataire: Ernest Gutmann - Yves Plasseraud S.A.S.
(86) Numéro de dépôt international: PCT/FR2020/000034
(87) Numéro de publication internationale: WO 2020/165510

(56) Documents cités:
- EP-A1- 3 346 513
- EP-A1- 3 346 513
- WO-A1-2015/136358
- WO-A1-2015/136358
- CN-A- 104 851 965
- FR-A1- 3 025 362
- FR-A1- 3 025 362
- JP-A- 2003 142 739
- JP-A- 2003 142 739
- JP-A- H1 197 751
- US-A- 5 168 339
- US-A- 5 411 599
- US-A1- 2009 025 770
- US-A1- 2017 279 027
- US-A1- 2017 279 027
- WENTING DONG ET AL: "Characterization of bismuth telluride aerogels for thermoelectric applications", MRS PROCEEDINGS, vol. 1306, 1 January 2011 (2011-01-01), XP055481391, DOI: 10.1557/opl.2011.475

## Description

### Domaine technique de l'invention

Dans un monde où la demande d'énergie augmente, le problème de la récupération et/ou de la production d'énergie est essentiel.

Les pertes de chaleur sont impliquées dans nombre de processus industriels. La thermoélectricité y a un rôle à jouer à travers l'effet Seebeck.

Par ailleurs, éviter de perdre une énergie utile (telle l'énergie thermique) ou éviter qu'une première température en perturbe une seconde, amène à considérer avec intérêt l'isolation active qui consiste à convertir l'énergie thermique en énergie électrique. Un matériau thermoélectrique performant nécessitera alors à la fois une conductivité électrique et un coefficient de Seebeck élevés et une faible conductivité thermique.

Notamment deux domaines d'applications de ce principe Seebeck ont d'ailleurs été identifiés:
- celui des dispositifs fonctionnant comme des capteurs ou détecteurs, pour des applications automobiles ou aéronautiques par exemple,
- celui des productions d'énergie électrique d'origine photovoltaïque.

Ces deux domaines peuvent avoir pour point commun la fonctionnalisation de certains matériaux thermiquement isolants possédant une faible conductivité thermique (λ≤ 100 mW/(m.K)) afin d'y ajouter, ou d'y utiliser, une capacité thermoélectrique (ajoutée par une charge ou intrinsèque au matériau).

Il peut s'agir dans les deux cas de dispositifs de détection de défaillance lié à une perte de vide.

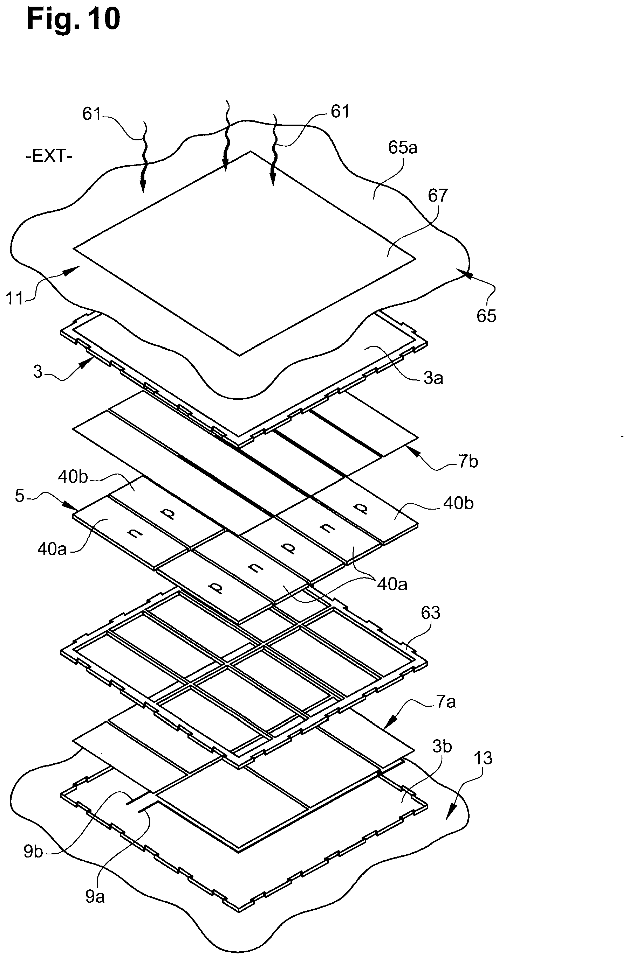

On doit comprendre ici un « dispositif photovoltaïque », comme un dispositif à capacité thermoélectrique (contenant un matériau thermoélectrique) adapté à fournir une énergie électrique en sortie (comme sur les bornes 9a,9b figure 10), s'il reçoit une énergie thermique, laquelle peut être celle issues de photons, de là le terme photovoltaïque. L'expression « dispositif thermoélectrique » lui convient donc aussi ; les deux sont synonymes.

Le document US 5168339 A1 décrit un dispositif thermoélectrique à semiconducteur ayant une structure poreuse scellée.

Le document CN 104851965 A décrit une méthode employant un aérogel de carbone dopé pour préparer un matériau thermoélectrique.

Le document de Wenting Dong et al., "Characterization of bismuth telluride aerogels for thermoelectric applications" ,MRS PROCEEDINGS, vol. 1306, 1 janvier 2011 (2011-01-01), XP055481391,DOI: 10.1557/opl.2011.475 décrit également l'emploi d'un tel aérogel.

Le document US 5411599 A1 décrit la fabrication d'un semiconducteur nanoporeux pour emploi comme matériau thermoélectrique.

Le document JP 2003/142739 A décrit un dispositif thermoélectrique capable de prévenir l'entrée d'humidité externe tout en maintenant un haut degré de performance.

Le document US 2017/279027 A1 décrit un dispositif thermoélectrique pour emploi dans un véhicule à moteur.

Le document FR 3025362 A1 un module de surveillance autonome à dispositifs thermoélectrique.

Le document EP 3346513 A1 décrit un dispositif de détection de défaillances pour un générateur de puissance, incluant un dispositif thermoélectrique.

Le document WO 2015/136358 A1 décrit un assemblage thermoélectrique comprenant des dispositifs thermoélectriques, un isolant et un collecteur de courant.

### Résumé de l'invention

L'invention a pour objet un dispositif de détection de défaillance par effet Seebeck selon la revendication 1.

Des caractéristiques optionnelles de ce dispositif sont proposées dans les revendications 2 à 4.

L'invention concerne en outre un assemblage selon la revendication 5 ou 6 et un véhicule selon la revendication 7 ou 8.« Qui peut être chargée au moins localement avec un matériau électriquement conducteur » indique que la matière de la matrice est adaptée à être chargée (donc sera ou non chargée) avec un matériau électriquement conducteur, et ceci sur tout ou partie de son volume et/ou de son épaisseur et/ou de sa surface. Le même sens relatif est à appliquer à l'expression ci-après : « qui peut n'occuper..qu'une partie mineure... ».

« Poreux » désigne un matériau possédant des interstices permettant le passage de l'air ou d'un gaz. Les matériaux poreux, à cellules ouvertes, incluent donc les mousses mais également les matériaux fibreux (tels que la laine de verre ou de roche).

Dans une recherche d'efficience, le rapport du volume des pores du matériau isolant thermique au volume occupé par ce matériau isolant thermique sera d'au moins 70%, à 10% près.

Il est précisé que l'expression pression s'entendra toujours comme absolue.

Un aérogel métallique, tel que du graphène, pourrait convenir en tant que matériau thermoélectrique poreux, et donc en tant que matrice en matériau isolant thermique. Dans ce cas, pas nécessairement besoin d'une charge de dit matériau électriquement conducteur. On pourra notamment se dispenser de charge si la conductivité électrique dépasse la valeur de 10³ S.m⁻¹, à 20% près.

Quoi qu'il en soit, par exemple dans un véhicule, on disposera avec la solution de l'invention d'un matériau qui, au sein d'un dispositif adapté, offrira une capacité thermoélectrique permettant de générer une certaine quantité d'électricité :
- et alors de participer à la gestion thermique de son environnement (par exemple, régulation thermique d'une batterie qui pourrait s'opérer en combinaison avec des MCP - matériau à changement de phase),
- ou de rendre disponible une certaine quantité d'énergie électrique, via un dispositif photovoltaïque.

Le terme « batterie » est à comprendre dans le présent texte comme « dispositif électrique (ou système d'alimentation d'énergie) qui chauffe et qui fonctionne dans une gamme privilégiée de températures qu'il importe de gérer ».

Batterie d'accumulateurs électriques et pile à combustion (ou à combustible) sont ici des synonymes de « batterie ».

Selon une autre caractéristique, il est proposé que, dans le matériau thermoélectrique poreux, la charge du matériau électriquement conducteur soit comprise en poids entre 1 % et 90 %, et de préférence 10 % et 80 %, du poids total du matériau isolant thermique, à 10% près.

Ainsi, le dopage sera homogène à travers le matériau et permettra d'atteindre un seuil de conductivité électrique optimisé.

Il est proposé que, dans le matériau thermoélectrique poreux, le matériau isolant thermique soit un matériau organique ou inorganique, en particulier un produit pyrolysé du même matériau organique ou inorganique, ou hybride organique-inorganique, en particulier d'une composition dérivée de sol-gel, plus particulièrement d'une composition dérivée du résorcinol et du formaldéhyde.organique-inorganique.

La pyrolyse permet d'augmenter la teneur en carbone du matériau, améliorant ainsi ses propriétés thermoélectriques.

Le produit pyrolysé pourra être un xérogel ou un aérogel de carbone.

Il est en outre proposé que le matériau thermoélectrique poreux comprenne une composition dérivée de sol-gel présentant une matrice poreuse.

Ainsi, en plus d'avoir de bonne propriétés de conductivité électrique, la porosité du matériau permettra de présenter des propriétés d'isolation thermique notablement favorables.

Il est par ailleurs proposé que le matériau inorganique soit du carbone et/ou de la silice.

Ces matériaux sont de bons candidats pour présenter de bonnes propriétés de conductivité électrique et d'isolation thermique, ce qui les rend intéressants en tant que matériaux thermoélectriques.

Il est en outre proposé que le matériau thermoélectrique poreux présente une densité inférieure à 300 kg/m3, de préférence inférieure à 200 kg/m3.

Ainsi, on obtiendra un compromis pertinent entre poids, effet d'isolation thermique et effet thermoélectrique.

Il est aussi proposé que le matériau thermoélectrique présente un coefficient Seebeck compris entre -100 µV/K et 100 µV/K.

Ainsi, pour quelques dizaines de degrés d'écart, entre la source chaude et la source froide, le matériau permettra de générer un voltage intéressant pour alimenter un capteur par exemple. Par ailleurs, II est proposé que ;
- si ledit matériau isolant thermique est organique, le matériau isolant thermique comprenne, ou soit choisi ou dérivé du groupe constitué par, (i) un polymère synthétique parmi le polystyrène, le polyuréthane, le polypropylène, le polyéthylène, la résine polyester, la résine phénolique, le résorcinol, formaldéhyde, urée-formaldéhyde, mélamine-formaldéhyde, crésol-formaldéhyde, phénol-furfural, résine mélamine, résine époxy, benzoxazine, polyimide, polyacrylamide, polyacrylonitrile, polyacrylate, polycyanurate, résine furanique, ou tout mélange de ceux-ci, et (ii) un polymère naturel parmi la cellulose, viscose et lin, ou tout mélange de ceux-ci.
- et, si le matériau isolant thermique est inorganique, le matériau isolant thermique comprenne ou, soit choisi ou dérivé du groupe constitué par, un oxyde d'aluminium, dioxyde de silicium, dioxyde de titane, oxyde de zinc, dioxyde de zirconium ou tout mélange de ceux-ci.

Ainsi, le matériau pourra être considéré comme un matériau thermoélectrique à caractéristiques optimisées.

Quelle que soit l'application retenue, un matériau thermoélectrique poreux, et notamment celui spécifique précité, pourra avantageusement être disposé dans une enveloppe, sous vide de préférence notamment dans une application en tant qu'élément d'un dispositif de détection de défaillance thermique d'un autre élément, l'aspect « sous vide » (pression interne absolue inférieure à 10⁵ Pa) n'étant pas critique pour une application dans un dispositif photovoltaïque, par exemple.

On notera qu'à titre d'autres matériaux thermoélectriques, on pourrait songer à utiliser, par exemple dans une application photovoltaïque, comme ci-après, un alliage silicium-germanium (SiGe), ou de tellurure de bismuth(III) Bi₂Te₃ (par exemple un alliage de bismuth et de tellure allié à Sb₂Te₃ (alliage d'antimoine et de tellure).

Il est précisé que le terme « câble » est générique et couvre les fils, nappes et tout élément allongé de cette nature assurant une liaison électrique.

Au moins s'il y a présence d'une enveloppe sous vide, le passage desdits câbles entre l'extérieur et l'intérieur de l'enveloppe se fera de façon étanche à l'air.

Pour favoriser la circulation électrique et la réalisation dudit élément électrique, il est proposé de compléter ce dernier avec des premier(s) et second(s) éléments électriquement conducteurs :
- situés vers deux côtés opposés du matériau thermoélectrique, lié électriquement avec ce matériau, et
- auxquels sont connectés les câbles conducteurs électriques.

Pour assurer par ailleurs de façon performante l'effet thermoélectrique attendu, il est proposé, par exemple dans une application photovoltaïque que le matériau thermoélectrique soit scindé en une pluralité d'unités de jonction disposées électriquement en série (et thermiquement en parallèle, si nécessaire) certaines unités de jonction ayant un coefficient Seebeck <0, d'autres un coefficient Seebeck >0, avec deux unités de jonction adjacentes reliées, alternativement, d'un premier côté du matériau thermoélectrique puis d'un second côté du matériau thermoélectrique.

Il est à noter que les expressions précitées « d'un premier côté... puis d'un second côté » et « situés vers deux côtés opposés » indiquent seulement que du matériau thermoélectrique est interposé entre lesdits côtés respectifs, pour que l'effet puisse thermoélectrique opérer. Dans l'application photovoltaïque, le dispositif photovoltaïque comprendra l'élément électrique précité, avec tout ou partie de ses caractéristiques.

Le termes « assemblage » et « ensemble » sont des synonymes dans le présent texte, le terme assemblage indique que les éléments constitutifs cités sont réunis ensemble, mais n'implique pas nécessairement que ces éléments sont fixés ensemble (assemblés).

Dans l'application « dispositif photovoltaïque », on pourra utilement préférer, pour l'efficacité thermoélectrique, qu'en tant que l'un de ces deux éléments thermiquement plus conducteurs, on trouve au moins un panneau vitré et/ou un concentrateur de flux thermique.

Sur un véhicule disposé dans un environnement extérieur et comprenant un dispositif photovoltaïque comme précité, le panneau vitré ou le concentrateur de flux thermique sera favorablement disposé pour être exposé à un flux lumineux naturel venant de l'extérieur du véhicule et qui le traversera, afin de tirer parti notamment de la luminosité de l'habitacle. Dans toute application, il pourra être préférable que l'élément électrique soit disposé dans une enveloppe au moins étanche à l'eau.

Il est aussi proposé que, dans l'élément électrique, chaque premier(s) et second(s) éléments électriquement conducteurs présente une conductivité électrique σ>10² S/m et, comme plus petite dimension, une épaisseur supérieure à 25 µm.

Ainsi, on favorisera un compromis pertinent entre encombrement et performance électrique. Dans le même but et pour viser aussi un compromis pertinent entre encombrement, poids et performance électrique, il est également proposé que l'épaisseur (e) du matériau thermoélectrique soit telle que e≥1mm.

Et pour favoriser aussi un compromis pertinent intégrant un aspect isolant thermique renforcé, comme dans une situation de de détection d'anomalies thermiques, il est aussi proposé que, toujours dans ledit élément électrique, le matériau thermoélectrique présente :
- une conductivité thermique λ<50mW/(m.K) à 20°C et une pression entre 10⁻²Pa et 10³Pa, en mode normal, sous ledit vide, et
- λ<150mW/(m.K) à 20°C et une pression atmosphérique de 10⁵ Pa, en mode défaillant, vide rompu.

Utiliser une enveloppe étanche comme précitée, fermée et sous vide, sera utile dans l'application « détecteur d'un maintien sous vide », puisque c'est l'enveloppe qui conditionnera l'existence du vide dont la présence sera alors à contrôler.

Dans ce cas, on peut noter qu'il existe déjà des structures thermiquement isolantes comprenant des matériaux thermiquement isolants, tels que du polystyrène, du polyuréthane, un aérogel ou encore un polymère naturel, tel que de la cellulose. Dans certaines de ces structures, le matériau thermiquement isolant est enfermé, sous vide (pression typiquement entre moins de 10⁵ Pa et 10⁻² Pa, à environ 20°C), dans une enveloppe scellée, étanche à l'air et à l'eau. On appelle souvent PIV (VIP en anglais) un tel produit.

Mais, même en prenant soin de la qualité de l'enveloppe étanche, les exigences de fiabilité dans le temps font qu'il faut envisager qu'elle peut perdre son étanchéité. Ceci aura comme conséquence une dégradation notable de l'isolation thermique, laquelle dépend du maintien sous vide.

Sous un aspect, la présente invention propose donc une solution pour détecter de façon efficiente une perte de vide dans une telle structure.

Ainsi, un utilisateur pourra être informé directement, via ce dispositif de communication d'information, d'une perte de vide, donc d'une anomalie thermique survenue.

Un avantage de la solution est son efficience. Ainsi, dans ce dispositif de détection, le matériau thermoélectrique pourra être intégré dans un matériau plus volumineux isolant thermique. Le matériau thermoélectrique (donc la partie pouvant générer un effet Seebeck) pourra former une matrice chargée électriquement et n'occuper qu'une partie mineure (potentiellement surface de moins de 50%) du matériau isolant thermique précité.

Ceci limitera aussi les coûts et facilitera la mise en œuvre de la solution.

Pour détecter les défaillances, comme précité, l'assemblage sera favorablement pourvu de capteurs de plusieurs températures réelles, ces capteurs étant reliés au calculateur pour que ladite donnée de référence soit fonction de ces températures et soit établie en fonction d'une différence entre deux de ces températures.

Ainsi, on affinera la qualité des mesures.

Un véhicule, en particulier automobile, étant aussi un aspect sur lequel porte l'invention, si ce véhicule est pourvu dudit dispositif de détection de défaillance, il sera à entraînement hybride ou électrique.

La gestion de la température d'une batterie électrique d'entraînement du véhicule, sur un véhicule à entraînement hybride ou électrique, disposé dans un environnement extérieur, étant critique, il est ici proposé, en relation avec ce qui précède, que ce véhicule comprenne justement :
- l'assemblage mentionné ci-avant, et
- en tant que l'un des deux éléments thermiquement plus conducteurs, un système de refroidissement ;
   -- disposé au contact thermique d'une batterie électrique d'entraînement du véhicule et
   -- dans lequel peut circuler un fluide d'apport de calories à la batterie ou de récupération de calories de celle-ci, et,
- en tant que l'autre des deux éléments thermiquement plus conducteurs, une plaque de protection exposée audit environnement extérieur.

Ainsi, on aura bien un gradient thermique naturellement établi entre la plaque de protection (qui peut être un élément de bas de caisse situé face à la route) et au système de refroidissement, tel qu'une plaque thermiquement conductrice située sous la batterie.

Pour détecter les défaillances, comme précité, sur ce véhicule, on pourra utilement prévoir que lesdits capteurs des températures réelles souhaitées comprennent au moins deux parmi :
- un capteur de température extérieure,
- un capteur de température du moteur, et
- un capteur de température de la batterie ou du système de refroidissement.

Sur ce véhicule, on pourra d'ailleurs prévoir que le système de refroidissement comprenne :
- des conduits dans lesquels peut circuler ledit fluide
- et un matériau à changement de phase (MCP) qui est adjacent auxdits conduits.

Ainsi, on pourra assurer une gestion avec « inertie thermique » (via le MCP) tirant parti des spécificités thermiques précitées de la solution.

A noter également que, quelle que soit l'application, et même si celle de détection de défaillance devrait peut-être en tirer le plus d'avantages, il est aussi proposé:
- que ledit matériau thermoélectrique présente :
   -- une densité inférieure à 300 kg/m3 et préférentiellement inférieure à 200 kg/m3,
   -- une conductivité électrique: entre 10 et 10⁶ S/m,
   -- un coefficient de Seebeck compris en -100 µV/K et 100 µV/K,
   -- une déformation inférieur à 2% à 0,1MPa ;
- et/ou que chaque premier(s) et second(s) éléments électriquement conducteurs présente une conductivité électrique σ>10² S/m, et de préférence σ>10³ S/m, et, comme plus petite dimension, une épaisseur inférieure à 8mm ;
- et/ou que l'épaisseur (e) du matériau thermoélectrique soit telle que 0,5mm<e<5mm.

Les paramètres et valeurs en cause permettent d'obtenir un produit :
- léger, si nécessaire très bon isolant thermique, fonctionnant avec un gradient de températures marqué entre ses faces opposées,
- à caractéristiques thermoélectriques très performantes, même sous faible épaisseur (possiblement e<3mm donc),
- à caractéristique d'isolation thermique du type de celle des aérogels.

L'invention sera si nécessaire encore mieux comprise et d'autres détails, caractéristiques et avantages de l'invention pourront apparaître à la lecture de la description suivante faite à titre d'exemple non limitatif en référence aux dessins annexés.

### Brève description des figures

[Fig. 1] est un schéma d'élément (repéré 1) thermiquement isolant à caractéristique thermoélectrique ;
[Fig. 2] est un éclaté (à gauche) de l'élément 1, schématisé complet à droite ;
[Fig. 3] schématise un véhicule équipé d'un dispositif (repéré 20) de détection de défaillance et d'un dispositif (repéré 60) « photovoltaïque » pouvant utiliser un tel élément 1 ;
[Fig. 4] détaille l'unité de traitement (repérée 15) associée à l'élément 1, dans le dispositif de détection de défaillance ; détail IV figure 3 ;
[Fig. 5] est un éclaté de l'ensemble formé par l'élément 1 entre deux éléments thermiquement plus conducteurs (repérés 11,13), pour former un assemblage en liaison avec lequel le dispositif 20 de détection peut opérer ;
[Fig. 6] montre en coupe transversale (suivant donc l'épaisseur), un passage dans des blocs de MCP ; détail VI de la figure 5 ;
[Fig. 7] schématise un élément 1 dont le matériau (à capacité isolante et thermoélectrique) est formé de blocs successivement n et p ;
[Fig. 8] détaille une possible telle construction ;
[Fig. 9] de même ; seuls deux des blocs successivement n et p y sont schématisés ; et
[Fig. 10] schématise plus en détail le dispositif photovoltaïque précité, conformément à une solution de l'invention, et
[Fig. 11] schématise une application de l'invention à l'alimentation électrique d'un capteur.

### Description détaillée de la solution proposée

Pour préparer un matériau thermoélectrique poreux (repéré 5/5a,5b sur différentes figures) utilisable par exemple dans le dispositif de détection de défaillance 20 ci-après, on pourra procéder comme suit :
a. préparation d'une suspension aqueuse colloïdale d'un précurseur sol-gel, d'origine phénolique.
b. ajout possible d'un précurseur de matériau électriquement conducteur à la suspension aqueuse colloïdale obtenue dans l'étape a., selon le seuil de conductivité électrique à atteindre.
c. et mélange sous ultrasons à une quantité prédéterminée en fonction de la conductivité électrique à obtenir dans le matériau final, notamment dans la gamme de 20 S/m à 10⁵ S/m.

Le précurseur de matériau électriquement conducteur sera destiné à être transformer en matériau électriquement conducteur, notamment sous forme de particules, à l'issue d'une étape de chauffage, notamment d'une pyrolyse, à une température T≥600 °C.

Ensuite, on pourra poursuivre comme suit :
d. le cas échéant, ajout au mélange obtenu dans l'étape b. d'un agent complexant (participant à la réticulation du réseau et donc créant une porosité favorable dans le matériau),
e. ajout d'un catalyseur au mélange obtenu dans l'étape c., jusqu'à atteindre de préférence un pH de 2 dans le cas de précurseurs de type phénoliques, le catalyseur initiant la polymérisation du mélange,
f. transfert du mélange obtenu dans l'étape d. dans un moule et gélification du mélange avec un couvercle fermé du moule à une température comprise entre 80 et 90 °C pendant au moins 24 heures,
g. une fois la gélification terminée, séchage du gel obtenu par évaporation du solvant avec le couvercle enlevé à une température inférieure à 100 °C, en particulier entre 90 et 99 °C, et
h. pyrolyse du gel séché obtenu dans l'étape f. dans un environnement inerte ou réducteur à une température T≥600 °C, en particulier entre 600 °C et 1200 °C, plus particulièrement entre 850 °C et 1050 °C.

En particulier, le précurseur d'un matériau isolant thermique dans l'étape a. peut être un composé phénolique choisi dans un groupe constitué de phénol, pyrocatéchol, résorcinol, catéchol, hydroquinone, pyrogallol, phloroglucinol, acide salicylique, phloroglucinol, méthylphénol, diméthylphénol, triméthylphénol, hydroxyméthylphénol, méthoxyphénol, méthylrésorcinol, éthylrésorcinol, et leurs mélanges.

Le composé phénolique peut être suspendu ou dissous dans l'eau, en quantité comprise entre 0.01 à 0.2 mole par mole d'eau, de préférence entre 0.06 to 0.14 par mole d'eau.

Avant l'étape c., un agent complexant peut être ajouté au mélange obtenu dans l'étape b., l'agent complexant étant choisi parmi un groupe constitué de poly(chlorure de diallyldiméthylammonium), poly(bromure de diallyldiméthylammonium), sels d'ammonium quaternaire, poly(chlorure de vinylpyridinium), poly(éthylèneimine), poly(vinylpyridine), poly(chlorhydrate d'allylamine), poly(chlorure de triméthylammonium éthyl méthacrylate), poly(acrylamide) chlorure de co-diméthylammonium), et leurs mélanges.

L'agent complexant peut être ajouté en quantité comprise entre 0.06 à 0.5 mole par mole du composé phénolique, de préférence 0.08 à 0.1 mole par mole du composé phénolique.

Le catalyseur dans l'étape c. peut être un acide choisi parmi un groupe constitué d'acide chlorhydrique, acide sulfurique, acide nitrique, acide acétique, acide phosphorique, acide trifluoroacétique, acide trifluorométhanesulfonique, acide perchlorique, acide oxalique, acide toluènesulfonique, acide dichloroacétique, acide formique, et leurs mélanges.

Le formaldéhyde peut être ajouté, dans un ratio massique de préférence de 0.5 par rapport au résorcinol, à l'étape a. ou après l'étape c. et l'étape d.

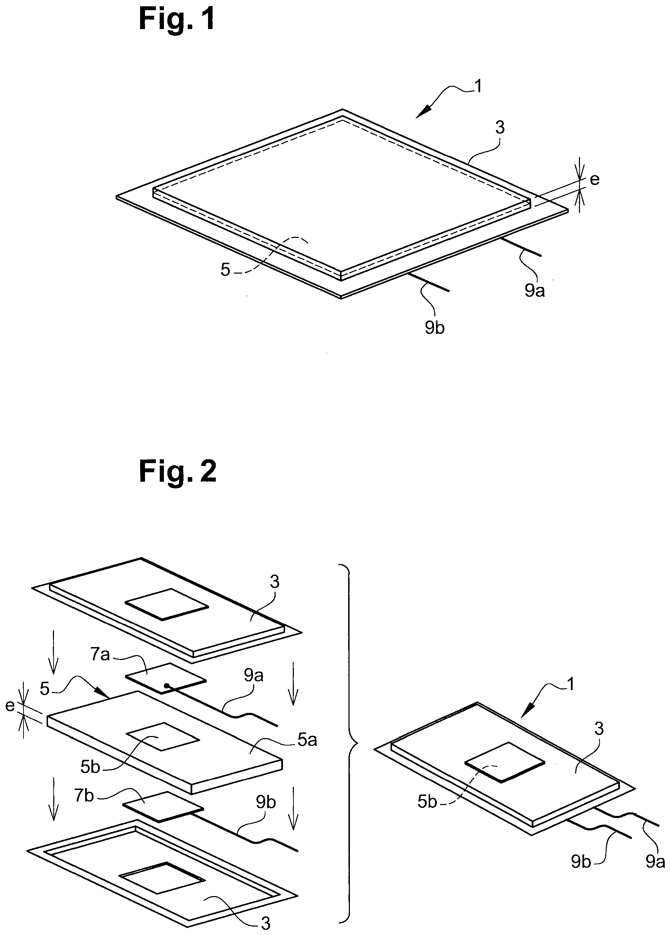

Sur la figure 1 et plus en détail sur la figure 2, on voit donc un élément 1 thermiquement isolant à caractéristique thermoélectrique comprenant :
- une enveloppe 3 thermiquement conductrice, de préférence étanche à l'eau, qui renferme ;
   -- le matériau thermoélectrique 5 poreux, qui est thermiquement isolant, et,
   -- au moins un premier et au moins un second éléments électriquement conducteurs 7a,7b situés, suivant l'épaisseur e, vers deux côtés opposés de la zone à capacité thermoélectrique (matrice chargée 5b dans l'exemple illustré) présent dans le matériau thermoélectrique 5 poreux, et
- une paire de câbles conducteurs électriques 9a,9b connectés aux éléments électriquement conducteurs, respectivement, et traversant l'enveloppe 3, de façon étanche à l'eau de préférence.

Chaque premier(s) et second(s) éléments 7a,7b électriquement conducteurs présentera favorablement une conductivité électrique σ>10² S/m et, comme plus petite dimension, une épaisseur supérieure à 25µm, mais pouvant être inférieure à 2mm, voire inférieure à 1mm. Ainsi, on associera un faible encombrement à une efficacité opérationnelle constatée. L'enveloppe 3 peut être un film plastique, un fin feuillet métallique ou une plaque métallique mise en forme - aluminium par exemple ; épaisseur de quelques 1/100mm à 1mm. Elle est plutôt thermiquement conductrice.

A toutes fins, il est précisé que l'on peut définir, à 20°C et sous pression atmosphérique :
- comme thermiquement conducteur, un moyen dont la conductivité thermique est λ≥100-150mW/(m.K) et
- comme thermiquement isolant, un moyen tel que λ≤100mW/(m.K).

Lesdits premier et second éléments électriquement conducteurs 7a,7b, pourront typiquement être des plaquettes, des petits blocs de pâte électro-conductrice, des coatings (revêtements par projection de poudre électrique) ou être formés par des dépôts par sérigraphie ou des sur-densifications.

Ils pourraient aussi être absents, remplacés, par des sur-dopages d'un composé conducteur électrique de part et d'autre de la jonction afin que l'on dispose en toute hypothèse d'un gradient en terme de conductivité électrique, entre deux côtés opposés du matériau thermoélectrique 5 poreux.

Dans la dernière hypothèse la paire de câbles conducteurs électriques 9a,9b sera connecté à la zone à capacité thermoélectrique du matériau 5, via les zones latérales sur-dopées.

Cette « zone à capacité thermoélectrique » est définie :
- par la matrice chargée 5b, si le matériau 5 contient au moins localement une charge de matériau électriquement conducteur, ou
- par la matrice en matériau isolant thermique 5a, voire tout le matériau 5 isolant thermique, si la conductivité électrique minimum (σ ≥10³ S.m⁻¹ à 20% près) est intrinsèque au matériau. Comme déjà mentionné, dans une application comme dispositif de détection de défaillance par effet Seebeck, l'enveloppe 3 sera favorablement étanche à l'air et scellée, pour permettre une mise sous vide interne.

Ainsi, on pourra coupler les détections d'une rupture du vide et d'une défaillance d'isolation thermique.

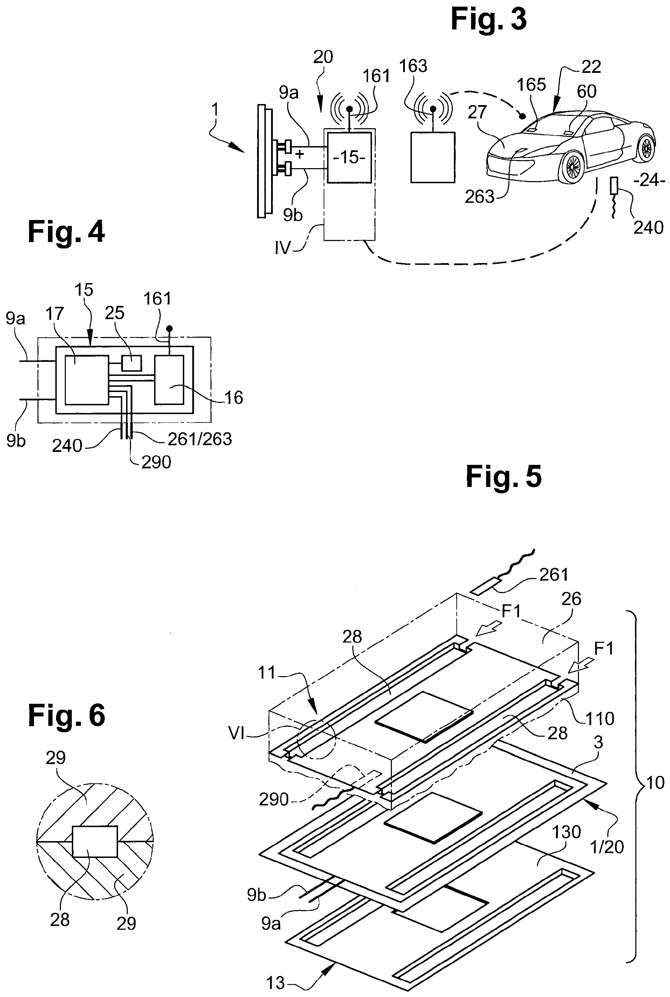

Ceci pourra en particulier être le cas sur un assemblage 10 (figure 5) comprenant :
- l'élément 1 thermiquement isolant à caractéristique thermoélectrique (dit aussi élément électrique) ou le dispositif de détection de défaillance précité 20), et
- deux éléments 11,13 thermiquement plus conducteurs que ledit élément électrique thermiquement isolant 1, de part et d'autre duquel les éléments thermiquement plus conducteurs 11,13 sont :
   -- disposés en contact thermique avec l'enveloppe 3 de l'élément 1 thermiquement isolant, et
   -- agencés pour être exposés opérationnellement l'un et l'autre à des températures différentes.

Ainsi, si les éléments 11,13 thermiquement plus conducteurs sont effectivement exposés à des températures différentes l'une de l'autre et si, avec une enveloppe 3 étanche à l'air, un vide interne qui régnait dans le volume interne de l'enveloppe est rompu (par une fuite du scellement par exemple), alors une énergie électrique née de l'effet Seebeck, qui existait avant rupture du vide, n'existe plus : Il n'y a plus (ou une forte décroissance) d'activité thermoélectrique. De fait, dès lors qu'il y aura eu rupture du vide, il y aura modification des flux thermiques mis en jeu ainsi que diminution du rendement thermoélectrique, créant ainsi un gap énergétique entre un matériau pour lequel le vide est maintenu et un matériau ayant perdu le vide. La température des éléments 11,13 va tendre vers une valeur commune.

C'est dans ce contexte d'identification d'un effet Seebeck qu'est d'ailleurs proposé figures 3-4 le dispositif 20 de détection de défaillance imaginé, qui comprend :
- « l'élément électrique » 1 précité, et
- une unité 15 de traitement comprenant :
   -- un calculateur 17,

a. pour comparer une donnée de référence avec une donnée issue d'un signal électrique d'entrée transmis depuis l'élément électrique 1 dans lesdits câbles 9a,9b, et
b. pour transmettre en sortie un premier signal si la comparaison desdites données est en-dessous d'un seuil, et un second signal si la comparaison desdites données est au-dessus du seuil, et
   -- un dispositif 16 de communication d'information relié au calculateur 17 et adressant une information qui sera fonction dudit premier ou second signal de sortie.

Ainsi on pourra :
- via le calculateur 17, détecter :
   -- un changement de signal électrique transmis du fait de l'effet Seebeck, et donc
   -- si le coefficient thermique λ de l'élément 1 thermiquement isolant a varié,
- et fournir à un utilisateur l'information issue du dispositif 16 de communication d'information. Le dispositif 16 de communication d'information peut inclure un émetteur 161 communiquant avec un récepteur 163, lequel peut lui-même communiquer (être relié) avec un afficheur ou enregistreur 165, tel qu'un écran, un voyant d'alerte ou une mémoire accessible d'un ordinateur de bord, par lequel ladite information adressée sera, immédiatement ou avec délai, communiquer à un occupant du véhicule ou à un opérateur de maintenance opérant pour vérifier l'état du vide dans l'enveloppe 3 et donc la qualité de l'isolation thermique locale.

Des capteurs de plusieurs températures réelles reliés au calculateur 17 vont en outre permettre que ladite « donnée de référence » précitée soit fonction de ces températures et soit établie en fonction d'une différence (TEG ci-après) entre deux de ces températures.

Ces capteurs (cf. figures 3-5) pourront en particulier comprendre au moins deux parmi :
- un capteur 240 de température extérieure Text,
- au moins un capteur 261 et/ou 263 de température Teng (au niveau) de la batterie 26 et/ou du moteur 27 de déplacement du véhicule 22 : moteur électrique ou moteurs électrique/thermique si le véhicule est hybride, et
- un capteur 290 de température Tcool (au niveau) du système de refroidissement 28/110/F1 (ce pourrait être la température instantanée du fluide F1, par exemple).

A partir de ces mesures de températures en temps réel, on pourrait par exemple prévoir ce qui suit :
- si Text<10°C, alors le système de refroidissement 28/110/F1 n'est pas fonctionnel (pas de circulation de fluide F1 dans les passages 28) et la différence TEG de température calculée par le calculateur 17 pour établir la « donnée de référence » à utiliser dans ladite comparaison est TEG = Text - Teng ;
- si Text>10°C, alors le système de refroidissement est fonctionnel ( circulation de fluide F1 dans les passages 28) et la différence de température calculée par le calculateur 17 devient TEG = Tcool - Teng = 10°C - Teng.

L'élément 1 thermoélectrique, ou module ici thermiquement isolant, subit en continu une différence de température entre son côté froid (Text ou Tcool, toujours inférieure ou égale à 10°C dans l'exemple) et son côté chaud (Teng) et produit donc en sortie 9a/9b une certaine énergie électrique (U ; I ; P).

Concernant le traitement de ce signal de sortie dans l'unité 15 de traitement (qui pourrait d'ailleurs être placée entre les éléments 163 et 165), cette unité 15 dispose, comme données d'entrée, des signaux électriques issus :
- des différents capteurs de température (240,261,263,290), et
- de l'élément 1.

Le calculateur 17 pourra avoir été programmé afin de déterminer si, en situation opérationnelle du véhicule 22 et selon la différence de température subie par l'élément 1, le signal électrique de sortie qu'il transmet (valeur de tension par exemple) est ou non au-dessus d'un certain seuil.

Un comparateur intégré au calculateur définira alors :
- si la valeur du signal est au-dessus du seuil : l'élément 1 est en état, voyant vert sur l'afficheur 165,
- si la valeur du signal est en-dessous du seuil : l'élément 1 est défaillant système (vide défaillant) : voyant rouge sur l'afficheur 165.

Le seuil sera ainsi une donnée de référence disponible en mémoire 25 du calculateur 17. Ce seuil, initialement fourni en mémoire 25, aura été calculé à partir d'essais préalables menés à différentes températures Text, Teng et Tcool et pour un(des) matériaux 5/5a,5b, et plus généralement un élément 1, voire un assemblage 10, identique(s) ou du moins comparable(s) à la solution opérationnelle montée sur le véhicule 22.

Du fait que, même avec une variation faible des signaux électriques entre les états thermiquement bien isolé (vide effectif) et mal isolé (vide rompu), cette variation pourra être détectée, le matériau à matrice chargée 5b pourra n'occuper, dans l'élément électrique 1, qu'une partie (c'est-à-dire une surface) mineure (donc moins de 50%) de la matrice 5a en matériau isolant thermique. Quelques cm2 pourrait suffire.

La figure 3 montre un véhicule 22 à entraînement hybride ou électrique disposé dans un environnement extérieur 24 et comprenant :
- l'assemblage 10 ou le dispositif 20,
- en tant que l'un, tel que 11, des deux éléments thermiquement plus conducteurs, une plaque de refroidissement 110; et,
- en tant que l'autre, tel que 13, des deux éléments thermiquement plus conducteurs, une plaque 130 de protection exposée audit environnement extérieur 24.

La plaque de refroidissement 110, thermiquement conductrice (métallique, telle que de l'acier), peut être disposée au contact thermique d'une batterie 26 électrique d'entraînement du véhicule ; cf. figure 5.

Dans la plaque de refroidissement 110 peut donc circuler un fluide F1 d'apport de calories à la batterie 26 ou de récupération de calories de celle-ci, tel que de l'eau, ou un fluide caloporteur ou réfrigérant.

Un système de refroidissement de la batterie 26 autre que la plaque 110 pourrait être prévu, tel un système de ventilation forcé d'un fluide venant en contact thermique avec la batterie, sur au moins une face de l'ensemble des accumulateurs électriques 260 qui la composent. La plaque 130 de protection peut être une plaque métallique - acier par exemple (donc plutôt thermiquement conductrice).

La plaque 110 de refroidissement pourra :
- être traversée suivant sa surface parallèle à la surface d'appui des modules/cellules de la batterie 26, par des conduits, ou passages, 28 dans lesquels pourra circuler ledit fluide F1,
- et comprendre, autour de ces conduits/passages 28, un ou plusieurs blocs de matériau 29 à changement de phase (MCP) adjacent auxdits conduits/passages, et donc en échange thermique avec ce MCP; cf. figure 6.

Ainsi, de l'énergie thermique pourra être récupérée dans ce MCP 29 et relarguée plus tard. Les passages 28 pourront être intégrées à la plaque 110, comme illustré.

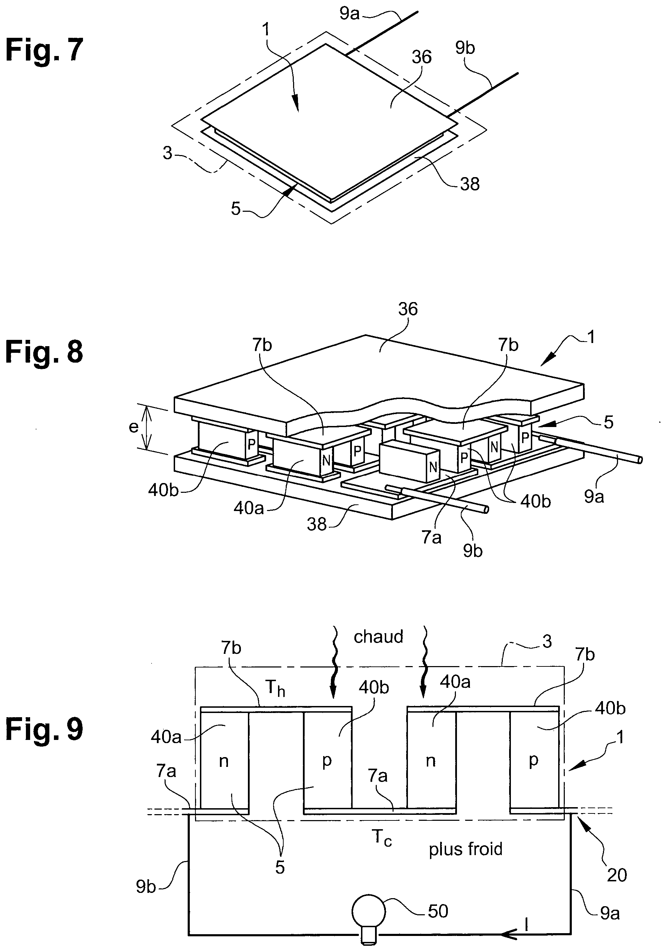

En liaison avec une application de production d'énergie électrique par effet Seebeck à d'autres fins que d'identification d'une défaillance, comme notamment à partir du rayonnement solaire (photovoltaïque), les figures 7-9 se réfèrent à un « élément électrique » 1 comme précité à ceci près que :
- le matériau thermoélectrique 5, n'est pas forcément un isolant thermique poreux, ou du moins pas nécessairement celui précité, et
- l'enveloppe 3, si elle est de préférence étanche à l'eau, comme le sera alors son scellement, n'a pas besoin d'être étanche à l'air. Au demeurant, on peut imaginer se dispenser d'enveloppe 3 ; voir figure 8.

Outre les câbles conducteurs électriques 9a,9b en liaison électrique avec ce matériau thermoélectrique 5, peuvent être aussi prévus des premier(s) et second(s) éléments électriquement conducteurs 7a,7b situés, vers deux côtés opposés des unités de jonction présentées ci-après comprenant chacune un bloc de matériau thermoélectrique 5.

Pour la construction/manipulation/sécurité, l'élément thermoélectrique 1 peut comprendre aussi, de part et d'autre des éléments électriquement conducteurs 7a,7b, des plaques ou substrats électriquement isolants et thermiquement conducteurs 36,38, par exemple en céramique, ceci pouvant être compléter ou remplacer par une enveloppe fermée 3.

Comme schématisé figures 7-10 le matériau 5 est maintenant scindé en une pluralité d'unités de jonction (ou blocs) disposées électriquement en série - et thermiquement en parallèle -, telles que celles 40a,40b pour deux d'entre elles situées côte à côte.

Plus précisément, pour obtenir un effet Seebeck important, on utilise alors, pour former le matériau 5, des assemblages de semi-conducteurs, formant lesdites unités de jonction 40a,40b, de types n et p en alternance.

Ces assemblages de semi-conducteurs, 40a,40b, sont reliés par des ponts métalliques, formés par les éléments électriquement conducteurs 7a,7b, et les porteurs de charges y sont respectivement des électrons et des trous, comme schématisé figures 8-10.

Suivant l'épaisseur des unités de jonction 40a,40b, donc du matériau 5, les éléments électriquement conducteurs 7a,7b, ici des plaquettes électriquement (et de préférence thermiquement) conductrices, connectent ensemble les semi-conducteurs 40a,40b..., électriquement en série.

Les jonctions assurées par ces éléments 7a,7b sont de deux types:
* p-n d'un côté (face supérieure, série d'éléments conducteurs 7b ; figures 8-10) et
* n-p du côté opposé (face inférieure, série d'éléments conducteurs 7a ; mêmes figures).

Ainsi, l'unité de jonction 40a (de type n) a un coefficient Seebeck <0 ; l'unité de jonction adjacente,40b (de type p) a un coefficient Seebeck >0.

Via l'effet Seebeck, un courant électrique (I) pourra être dissipé dans une résistance de sortie symbolisée par l'ampoule 50 sur la figure 9.

Comme schématisé sur cette figure 9, l'élément thermoélectrique 1 reçoit donc une certaine énergie thermique, flèches 61 : quantité de chaleur via une source chaude dans l'exemple ; mais ce pourrait être des frigories, avec des unités de jonction n et p organisées en conséquence.

Cette puissance thermique fournie est, pour partie, transformée en travail par l'élément 1, sous forme d'un courant de sortie (I), à travers les jonctions n-p et p-n alternées, successives. C'est un tel principe qui opère sur le dispositif 60 photovoltaïque de l'invention, que l'on peut aussi dénommer dispositif thermoélectrique, car un énergie thermique 61 apportée autrement que par des photons pourrait lui être fournie.

Sur ce dispositif 60 photovoltaïque, on retrouve, comme schématisé figure 10, l'élément 1 précité schématisé figures 7-9, à ceci près que les plaques 36,38 sont remplacées par une enveloppe fermée 3 comprenant deux couvercles 3a-3b complémentaires pouvant contenir entre eux, empilés lesdits premier(s) et second(s) éléments électriquement conducteurs 7a,7b entre lesquels sont interposées les successions alternées d'unités de jonction 40a (de type n) et unité de jonctions adjacentes 40b (de type p).

Réunis périphériquement, les deux couvercles 3a-3b formeront une enveloppe fermée 3 étanche à l'eau traversée par les conducteurs 9a,9b. Cette traversée peut être étanche à l'air.

Pour leur stabilité, les unités de jonction 40a (de type n) et 40b (de type p) pourront être reçues dans un cadre 63 à claire-voie, isolant électrique.

A travers ce cadre, les unités de jonction 40a,40b sont en contact électrique avec les éléments électriquement conducteurs 7a,7b de façon (comme illustré figure 10) qu'un courant électrique puisse être produit dans les conducteurs 9a,9b si, comme schématisé figure 10, l'élément thermoélectrique 1 reçoit donc une certaine énergie thermique : flèches 61 ; en l'espèce un flux lumineux naturel venant de l'extérieur du véhicule 22 sur lequel le dispositif 60 photovoltaïque aura pu être installé ; voir figure 3.

Dans cette hypothèse, le véhicule 22 pourra être à moteur thermique et les conducteurs 9a,9b être connectés à un appareillage électrique adapté à fonctionner ainsi.

Comme donc schématisé figure 10, la disposition des éléments électriquement conducteurs 7a,7b est :
- suivant une succession de lamelles parallèles, de l'élément conducteur 7b, chacune couvrant deux unités, respectivement 40a,40b, allongées pareillement,
- et suivant celle en carrés de l'élément conducteur 7a, chacun couvrant deux unités, respectivement 40a,40b, côte-à-côte transversalement à la direction précédente d'allongement.

Avec un matériau thermoélectrique 5 poreux formant les unités de jonction 40a,40b, on favorisera un important gradient thermique entre les deux côtés ou faces opposés de l'élément électrique 1.

Sur le véhicule 22, l'un 11 des deux éléments thermiquement plus conducteurs 11,13 précités comprendra ou sera formé par un panneau 65, de préférence vitré, ou un concentrateur de flux thermique 67, tous deux alors adaptés pour être traversés par les rayons lumineux du soleil, pour l'effet photovoltaïque attendu.

Dans le mode de réalisation illustré, l'élément 11 coiffe l'un des couvercles 3a, par-dessus l'élément conducteur 7b.

Si on utilise un concentrateur de flux thermique 67, celui-ci sera utilement disposé dans un panneau 65 qui pourra ne pas être vitré, tel qu'une tôle ou un panneau plastique rigide non transparent du véhicule 22 exposé en face extérieure 65a à l'environnement extérieur (EXT) et donc au soleil.

Le deuxième élément thermiquement plus conducteur 13 sera situé plus à l'intérieur du véhicule 22 que l'élément 11. Il pourra s'agir d'un panneau de doublure intérieure contre lequel sera appliqué le dispositif 60 photovoltaïque par son couvercle 3b.

Pour chiffrer encore la solution proposée quelle que soit l'application, et dans une optique d'efficience, de légèreté et de faible encombrement, il est proposé :
- que chaque premier(s) et second(s) éléments électriquement conducteurs 7a, 7b présente une conductivité électrique σ>102 S/m et, comme plus petite dimension, une épaisseur comprise entre 25µm et 5cm, de préférence inférieure à 1cm, voire à 5mm,
- que l'épaisseur (e) du matériau thermoélectrique 5 soit telle que 0.5mm<e<10cm et préférentiellement 0,8mm<e<1cm.

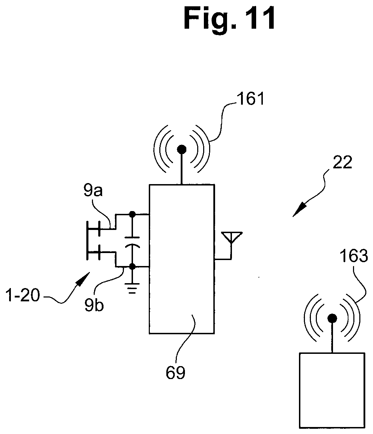

Une autre application est schématisée figure 11. Il s'agit d'un cas où l'élément électrique 1 est connecté électriquement à un capteur 69 de paramètre(s), tel qu'un paramètre physique (température, pression, vibration, humidité, déformation, en particulier, voire autre). L'énergie électrique produite par l'élément électrique 1 sert de source d'alimentation électrique au capteur 69, via les câbles 9a,9b.

L'élément électrique 1 peut être remplacé par le dispositif de détection de défaillance 20 (de là le repère 1-20 figure 11).

Utilisé dans le contexte du véhicule 22, le capteur 69 sera utilement connecté ou en communication avec le, ou pourvu du, dispositif 16 de communication d'information équipé de l'émetteur 161 adapté pour communiquer avec le récepteur 163.

Le couple élément électrique 1 (ou dispositif de détection de défaillance 20) et capteur 69 permettra d'élargir le champ d'acquisition d'un paramètre (autosuffisance énergétique/faible énergie/autonomie).

## Revendications

1. Dispositif (20) de détection de défaillance par effet Seebeck comprenant :
- un élément électrique (1) comprenant:
-- un matériau thermoélectrique (5 ;5a,5b), et,
-- des câbles conducteurs électriques (9a,9b) en liaison électrique avec ledit matériau thermoélectrique, et dans lequel :
a) le matériau thermoélectrique comprend une matrice (5a) en un matériau isolant thermique, chargée au moins localement avec un matériau électriquement conducteur (5b) pour définir un matériau à matrice chargée qui peut n'occuper, dans l'élément électrique, qu'une partie mineure de la matrice (5a) en matériau isolant thermique, ladite partie mineure correspondant à une surface inférieure à 50% d'une surface totale de la matrice (5a) en matériau isolant thermique, ou
b) le matériau thermoélectrique (5 ;5a,5b) :
- est poreux,
- présente, à 20°C et à pression atmosphérique, une conductivité thermique inférieure à 100 mW/(m.K) et, à l'endroit d'au moins une zone à capacité thermoélectrique, une conductivité électrique comprise entre 10 S/m et 10⁵ S/m, et
- comprend une matrice en un matériau isolant thermique :
-- qui présente une porosité supérieure à 70%, et
-- qui peut être chargée au moins localement avec un matériau électriquement conducteur (5b), la charge du matériau électriquement conducteur étant comprise en poids entre 0% et 90% du poids total du matériau isolant thermique,
- le dispositif (20) de détection de défaillance comprenant en outre une enveloppe (3) renfermant le matériau thermoélectrique (5 ;5a,5b) et qui :
-- est étanche à l'air et à l'eau, sous vide, et
-- est traversée par les câbles conducteurs électriques (9a,9b),
- le dispositif (20) de détection de défaillance comprenant en outre un capteur (69) alimenté en tension à partir dudit matériau thermoélectrique (5 ;5a,5b), et
- le dispositif (20) de détection de défaillance comprenant en outre une unité de traitement qui est reliée à l'élément électrique (1) et qui comprend :
-- un calculateur (17) :
--- pour comparer une donnée de référence avec une donnée issue d'un signal électrique d'entrée transmis depuis l'élément électrique (1) dans lesdits câbles,
et
--- pour transmettre en sortie un premier signal si la comparaison desdites données est en-dessous d'un seuil, et un second signal si la comparaison desdites données est au-dessus du seuil, et
-- un dispositif (16) de communication d'information relié au calculateur et adressant une information fonction dudit premier ou second signal de sortie.

2. Dispositif selon la revendication 1, dans lequel :
- l'élément électrique (1) comprend en outre des premier(s) et second(s) éléments électriquement conducteurs (7a,7b) situés vers deux côtés opposés du matériau thermoélectrique, et auxquels sont connectés les câbles conducteurs électriques (9a,9b),
- chaque premier(s) et second(s) éléments électriquement conducteurs (7a,7b) présente une conductivité électrique σ>10²S/m et, comme plus petite dimension, une épaisseur supérieure à 25µm, et
- le matériau thermoélectrique (5,5b) présente une épaisseur (e) telle que 0.5mm<e<10cm.

3. Dispositif selon l'une quelconque des revendications précédentes, dans lequel le matériau thermoélectrique (5 ; 5a,5b) définit une unique jonction électrique, de sorte qu'il est dépourvu d'une pluralité d'unités de jonction (40a,40b) disposées électriquement en série, certaines unités de jonction ayant un coefficient Seebeck <0, d'autres un coefficient Seebeck >0, avec deux unités de jonction adjacentes reliées, alternativement, d'un premier côté du matériau thermoélectrique (5a) puis d'un second côté du matériau thermoélectrique (5b).

4. Dispositif selon l'une quelconque des revendications précédentes, dans lequel :
- la charge du matériau électriquement conducteur (5b) est comprise en poids entre 1 % et 90 %, et de préférence 10 % et 80 %, du poids total du matériau isolant thermique, et/ou
- le matériau thermoélectrique présente un coefficient de Seebeck compris entre -100 µV/K et 100 µV/K, et/ou
- le matériau thermoélectrique présente une densité inférieure à 300 kg/m³, de préférence inférieure à 200 kg/m³.

5. Assemblage comprenant :
- le dispositif de détection de défaillance selon l'une quelconque des revendications 1 à 4, et,
- deux éléments (11,13) thermiquement plus conducteurs que ledit élément électrique (1) de part et d'autre duquel les éléments thermiquement plus conducteurs (11,13) sont :
-- disposés en contact thermique avec l'élément électrique, et
-- agencés pour pouvoir être soumis à des températures différentes l'un de l'autre, de sorte que, un gradient thermique étant ainsi créé entre deux faces opposées de l'élément électrique, une énergie électrique soit produite par effet Seebeck dans les câbles conducteurs électriques (9a,9b).

6. Assemblage selon la revendication 5, comprenant :
- ledit dispositif de détection de défaillance, et,
- des capteurs (240,261,263,290) de plusieurs températures réelles, reliés au calculateur (17) pour que ladite donnée de référence soit fonction de ces températures réelles et soit établie en fonction d'une différence entre deux de ces températures.

7. Véhicule (22) à entraînement hybride ou électrique, disposé dans un environnement extérieur et comprenant :
- au moins un moteur (27) d'entraînement,
- le dispositif de détection de défaillance selon l'une quelconque des revendications 1 à 4.

8. Véhicule (22) à entraînement hybride ou électrique, disposé dans un environnement extérieur et comprenant :
- au moins un moteur (27) d'entraînement, et
- l'assemblage selon la revendication 5 ou 6, et
- en tant que l'un (11) des deux éléments thermiquement plus conducteurs, un système de refroidissement (110,F1,28) :
-- disposé au contact thermique d'une batterie électrique (26) d'entraînement du véhicule et
-- dans lequel peut circuler un fluide (F1) d'apport de calories à la batterie ou de récupération de calories de celle-ci, et,
- en tant que l'autre (13) des deux éléments thermiquement plus conducteurs, une plaque (130) de protection exposée audit environnement extérieur.

## Patentansprüche

1. Vorrichtung (20) zur Fehlererkennung mittels Seebeck-Effekt, umfassend:
- ein elektrisches Element (1), umfassend:
-- ein thermoelektrisches Material (5; 5a, 5b) und
-- elektrische Leitungsdrähte (9a, 9b) in elektrischer Verbindung mit dem thermoelektrischen Material, wobei:
a) das thermoelektrische Material eine Matrix (5a) aus einem wärmeisolierenden Material umfasst, welche zumindest abschnittsweise mit einem elektrisch leitenden Material (5b) beladen ist, um ein beladenes Matrixmaterial zu bilden, das im elektrischen Element nur einen geringfügigen Teil der Matrix (5a) aus wärmeisolierendem Material einnehmen kann, wobei der geringfügige Teil einer Fläche von weniger als 50 % einer Gesamtfläche der Matrix (5a) aus wärmeisolierendem Material entspricht, oder
b) das thermoelektrische Material (5; 5a, 5b)
- porös ist,
- bei 20°C und atmosphärischem Druck eine Wärmeleitfähigkeit von weniger als 100 mW/(m.K) und an zumindest einer Stelle mit thermoelektrischer Kapazität eine elektrische Leitfähigkeit zwischen 10 S/m und 10⁵ S/m aufweist, und
- eine Matrix aus einem wärmeisolierenden Material umfasst,
-- die eine Porosität von mehr als 70 % aufweist und
-- die zumindest abschnittsweise mit einem elektrisch leitfähigen Material (5b) beladen werden kann, wobei der Anteil an elektrisch leitfähigem Material zwischen 0 Gew.-% und 90 Gew.-% des Gesamtgewichts des wärmeisolierenden Materials beträgt,
- wobei die Fehlererkennungsvorrichtung (20) ferner eine Hülle (3) umfasst, die das thermoelektrische Material (5; 5a, 5b) umschließt und die
-- unter Vakuum luft- und wasserdicht ist und
-- von den elektrischen Leitungsdrähten (9a, 9b) durchquert wird,
- wobei die Fehlererkennungsvorrichtung (20) ferner einen Sensor (69) umfasst, der von dem thermoelektrischen Material (5; 5a, 5b) mit Spannung versorgt wird, und
- wobei die Fehlererkennungsvorrichtung (20) ferner eine Verarbeitungseinheit umfasst, die mit dem elektrischen Element (1) verbunden ist und umfasst:
-- einen Rechner (17)
--- zum Vergleichen von Referenzdaten mit Daten, die aus einem elektrischen Eingangssignal stammen, das von dem elektrischen Element (1) an die Leitungsdrähte übertragen wird,
--- zum Ausgeben eines ersten Signals, wenn der Vergleich der Daten einen Schwellenwert unterschreitet, und zum Ausgeben eines zweiten Signals, wenn der Vergleich der Daten den Schwellenwert überschreitet, und
-- eine Informationskommunikationsvorrichtung (16), die mit dem Rechner verbunden ist und eine Information in Abhängigkeit von dem ersten oder zweiten Ausgangssignal adressiert.

2. Vorrichtung nach Anspruch 1, wobei
- das elektrische Element (1) ferner erste und zweite elektrisch leitende Elemente (7a, 7b) umfasst, die sich an zwei gegenüberliegenden Seiten des thermoelektrischen Materials befinden und mit denen die elektrischen Leitungsdrähte (9a, 9b) verbunden sind,
- jedes erste und zweite elektrisch leitende Element (7a, 7b) eine elektrische Leitfähigkeit von σ > 10² S/m und als kleinste Abmessung eine Dicke von mehr als 25 µm aufweist, und
- das thermoelektrische Material (5, 5b) eine Dicke (e) aufweist, sodass 0,5 mm < e < 10 cm.

3. Vorrichtung nach einem der vorstehenden Ansprüche,
wobei das thermoelektrische Material (5; 5a, 5b) einen einzigen elektrischen Übergang definiert, so dass es frei von einer Vielzahl von elektrisch in Reihe geschalteten Übergangseinheiten (40a, 40b) ist, wobei einige Übergangseinheiten einen Seebeck-Koeffizienten < 0 und andere einen Seebeck-Koeffizienten > 0 aufweisen, wobei zwei benachbarte Übergangseinheiten abwechselnd mit einer ersten Seite des thermoelektrischen Materials (5a) und dann mit einer zweiten Seite des thermoelektrischen Materials (5b) verbunden sind.

4. Vorrichtung nach einem der vorstehenden Ansprüche, wobei
- die Beladung mit elektrisch leitfähigem Material (5b) zwischen 1 Gew.-% und 90 Gew.-%, vorzugsweise zwischen 10 Gew.-% und 80 Gew.-%, des Gesamtgewichts des wärmeisolierenden Materials beträgt, und/oder
- das thermoelektrische Material einen Seebeck-Koeffizienten aufweist, der zwischen -100 µV/K und 100 µV/K liegt, und/oder
- das thermoelektrische Material eine Dichte von weniger als 300 kg/m³, vorzugsweise weniger als 200 kg/m³, aufweist.

5. Anordnung, umfassend:
- die Fehlererkennungsvorrichtung nach einem der Ansprüche 1 bis 4 und
- zwei Elemente (11, 13), die thermisch leitfähiger sind als das elektrische Element (1), wobei die thermisch leitfähigeren Elemente (11, 13) auf beiden Seiten des elektrischen Elements
-- in thermischem Kontakt mit dem elektrischen Element angeordnet sind,
-- und so angeordnet sind, dass sie unterschiedlichen Temperaturen ausgesetzt werden können, so dass aufgrund eines dadurch zwischen zwei gegenüberliegenden Seiten des elektrischen Elements erzeugten Temperaturgefälles eine elektrische Energie durch Seebeck-Effekt in den elektrischen Leitungsdrähten (9a, 9b) erzeugt wird.

6. Anordnung nach Anspruch 5, umfassend:
- die genannte Fehlererkennungsvorrichtung und
- Sensoren (240, 261, 263, 290) für mehrere Ist-Temperaturen, die mit dem Rechner (17) verbunden sind, damit die Referenzdaten Funktion dieser Ist-Temperaturen sind und in Abhängigkeit von einer Differenz zwischen zwei dieser Temperaturen ermittelt werden.

7. Fahrzeug (22) mit Hybrid- oder Elektroantrieb, das in einer Außenumgebung angeordnet ist und umfasst:
- zumindest einen Antriebsmotor (27),
- die Fehlererkennungsvorrichtung nach einem der Ansprüche 1 bis 4.

8. Fahrzeug (22) mit Hybrid- oder Elektroantrieb, das in einer Außenumgebung angeordnet ist und umfasst:
- zumindest einen Antriebsmotor (27),
- die Anordnung nach Anspruch 5 oder 6, und
- als eines (11) der beiden thermisch leitfähigeren Elemente ein Kühlsystem (110, F1, 28),
-- das in thermischem Kontakt mit einer elektrischen Antriebsbatterie (26) des Fahrzeugs angeordnet ist und
-- in dem ein Fluid (F1) strömen kann, das der Batterie Wärme zuführt oder Wärme von ihr zurückgewinnt, und
- als das andere (13) der beiden thermisch leitfähigeren Elemente eine Schutzplatte (130), die der Außenumgebung ausgesetzt ist.

## Claims

1. A failure-detection device (20) by Seebeck effect comprising
- an electrical element (1) comprising:
-- a thermoelectric material (5;5a,5b), and
-- electrically conductive cables (9a,9b) in electrical connection with said thermoelectric material, and in which electrical element :
a) the thermoelectric material comprises a matrix (5a) of a thermally insulating material provided at least locally with electrically conductive material (5b) to define a filled matrix material which may occupy, in the electrical element, only a minor part of the matrix (5a) of thermally insulating material, said minor part corresponding to a surface area less than 50% of a total surface area of the matrix (5a) of thermally insulating material, or
b) the thermoelectric material (5;5a,5b):
- is porous,
- has, at 20°C and at atmospheric pressure, a thermal conductivity of less than 100 mW/(m.K) and, at the location of at least one zone having a thermoelectric capacity, has an electrical conductivity of between 10 S/m and 10⁵ S/m, and
- comprises a matrix of a thermally insulating material:
-- which has a porosity of more than 70%, and
-- which may be provided at least locally with an electrically conductive material (5b), the content of the electrically conductive material being between 0% and 90% by weight of the total weight of the thermal insulating material,
- the failure-detection device (20) further comprising an envelope (3) enclosing the thermoelectric material (5; 5a, 5b) and which:
-- is air and watertight, vacuum-tight, and
-- is crossed by the electrical conductor cables (9a, 9b),
- the failure-detection device (20) further comprising a sensor (69) supplied with voltage from said thermoelectric material (5;5a,5b), and
- the failure-detection device (20) further comprising a processing unit connected to the electrical element (1) and comprising:
-- a calculator (17):
--- to compare a reference data with a data item issued from an input electric signal transmitted from the electric element (1) in said cables, and
--- to output a first signal if the comparison of said data is below a threshold, and a second signal if the comparison of said data is above the threshold, and
-- an information communication device (16) connected to the calculator and addressing information depending on said first or second output signal.

2. The device according to claim 1, wherein:
- the electrical element (1) further comprises first and second electrically conductive elements (7a, 7b) located towards two opposite sides of the thermoelectric material, and to which the electrical conductor cables (9a, 9b) are connected,
- each first electrically conductive element and second electrically conductive element (7a, 7b) has an electrical conductivity σ>10²S/m and, as a smallest dimension, a thickness of more than 25µm, and
- the thermoelectric material (5,5b) has a thickness (e) such that 0.5mm<e<10cm.

3. The device according to any of the preceding claims, wherein the thermoelectric material (5 ; 5a, 5b) defines a single electrical junction, so that it is devoid of a plurality of junction units (40a, 40b) arranged electrically in series, some junction units having a Seebeck coefficient <0, other junction units having a Seebeck coefficient >0, with two adjacent junction units connected, alternately, on a first side of the thermoelectric material (5a) and then on a second side of the thermoelectric material (5b).

4. The device according to any one of the preceding claims, wherein:
- the filling of the electrically conductive material (5b) is between 1% and 90%, preferably 10% and 80%, by weight of the total weight of the thermal insulating material, and/or
- the thermoelectric material has a Seebeck coefficient between -100 µV/K and 100 µV/K, and/or
- the thermoelectric material has a density of less than 300 kg/m³, preferably less than 200 kg/m³.

5. An assembly including:
- the failure-detection device according to any one of claims 1 to 4, and,
- two elements (11, 13) thermally more conductive than said electrical element (1) on either side of which the thermally more conductive elements (11, 13) are:
-- disposed in thermal contact with the electrical element, and
-- arranged to be capable of being subjected to temperatures different from each other, so that, with a thermal gradient thus created between two opposite faces of the electrical element, electrical energy is generated by the Seebeck effect in the electrical conductor wires (9a, 9b).

6. The assembly according to claim 5, comprising:
- said failure-detection device, and
- sensors (240, 261, 263, 290) for sensing a plurality of actual temperatures, connected to the calculator (17) so that said reference data is a function of the actual temperatures and is established as a function of a difference between two of said actual temperatures.

7. A hybrid or electrically driven vehicle (22) disposed in an outdoor environment and comprising:
- at least one drive motor (27),
- the failure-detection device according to any of claims 1 to 4.

8. A hybrid or electrically driven vehicle (22) disposed in an outdoor environment and comprising:
- at least one drive motor (27), and
- the assembly according to claim 5 or 6, and
- as one (11) of the two more thermally conductive elements, a cooling system (110, F1, 28):
-- disposed in thermal contact with an electric drive battery (26) of the vehicle and
-- in which a fluid (F1) for supplying calories to the battery or for recovering calories from the battery can circulate, and,
- as the other (13) of the two more thermally conductive elements, a protective plate (130) exposed to said external environment.
